# DEMANDE DE BREVET EUROPEEN

(11) **EP 2 023 380 A1**
(43) Date de publication de la demande: **11.02.2009**
(21) Numéro de dépôt: 08160680.8
(22) Date de dépôt: 18.07.2008
(51) Int. Cl.: H01L 21/18, H01L 21/762, H01L 21/00

(54) **Procédé et installation pour la fracture d'un substrat composite selon un plan de fragilisation**

(30) Priorité: 08.08.2007 FR 0756997
(71) Demandeur: S.O.I. TEC Silicon on Insulator Technologies, 38190 Bernin (FR)
(72) Inventeur: Legros, David, 38190, FROGES (FR)
(74) Mandataire: Boura, Olivier

(57) **Abrégé**

L'invention concerne un procédé de fracture d'une structure composite (100) selon un plan de fragilisation défini entre deux couches, le procédé comprenant la réalisation d'une fracture de la structure le long du plan de fragilisation. Lors de la fracture, la structure composite est disposée dans un logement (120) de nacelle et maintenue en contact contre des raidisseurs (118) disposés de part et d'autre de la structure et alignés parallèlement l'un à l'autre.

## Description

### Arrière-plan de l'invention

La présente invention se rapporte au domaine général de la fabrication de structures composites utilisées notamment pour l'épitaxie de matériaux du groupe III/N tels que le GaN, AlGaN, InGaN ou de matériaux du groupe III/V tels que GaAs ou de matériaux du groupe IV tels que le Germanium. Les domaines d'application de l'invention sont l'électronique, l'optique et l'optoélectronique.

L'invention concerne plus précisément un procédé de fracture d'une structure composite selon un plan de fragilisation défini entre deux couches, le procédé comprenant la réalisation d'une fracture de la structure le long du plan de fragilisation.

Les structures composites peuvent être fabriquées selon la technologie Smart Cut^{®}. Cette technologie permet de fabriquer une structure composite par report d'une couche mince sur un substrat support.

Un exemple de mise en oeuvre de la technologie Smart Cut^{®} appliqué à la réalisation de plaques de SOI est notamment décrit dans le document US 5 374 564 ou dans l'article de A.J. Auberton-Hervé et al. intitulé « Why can Smart-Cut Change the future of microelectronics ? », Int. Journal of High Speed Electronics and Systems, Vol.10, No1, 2000, p.131-146.

D'une manière générale, la technologie Smart Cut^{®} consiste à implanter des espèces ioniques sous une face du substrat donneur pour former un plan de fragilisation, à mettre en contact intime la face du substrat donneur soumise à l'implantation avec un substrat support, à effectuer un traitement thermique de stabilisation du collage, et à réaliser une fracture de la structure ainsi obtenue au niveau du plan de fragilisation pour transférer la partie de la structure située entre la surface soumise à l'implantation et le plan de fragilisation sur le substrat support. La fracture de la structure peut être réalisée par un recuit thermique à une température donnée et/ou par apport d'une énergie mécanique. La couche du substrat donneur délimitée entre le plan de fragilisation et la face qui a subi l'implantation est ainsi reportée sur le substrat support.

La couche restante du substrat donneur, appelée le « négatif », est recyclée après polissage et nettoyage de sa surface pour être utilisée à nouveau comme substrat donneur dans un nouveau transfert de couche mince.

Le substrat donneur nécessite une fabrication particulière pour présenter une faible densité de défauts. Il est donc particulièrement coûteux. Aussi, le recyclage du négatif est particulièrement important pour diminuer les coûts de fabrication.

Or, lors de l'utilisation de substrats donneurs en matériau dur et cassant (tel que le GaN, le SiC) ou en matériau très fragile (tel que le germanium ou le silicium), la fracture de structures disposées à l'horizontale ou à la verticale peut conduire à la casse de 80% des négatifs. Au moment de la fracture, l'énergie libérée, qui peut être localement très forte, peut en effet provoquer la casse des négatifs.

Il existe différentes solutions pour améliorer le transfert de couche mince par fracture dans un substrat.

L'une de ces solutions connues est décrite dans le document WO 2006/093817. Elle prévoit de réduire la formation de défauts (bullages, fissures, fractures) dans la couche transférée qui apparaissent lors de l'application de l'énergie de fracture. A cet effet, ce document propose la fixation par un procédé de collage d'un substrat formant un raidisseur sur la face arrière du substrat support ou donneur.

Une autre solution connue et décrite dans le document US 6 858 517 s'applique plus particulièrement au transfert d'une couche mince à partir d'un substrat donneur fragilisé sur un substrat support dont le coefficient de dilatation thermique est différent de celui du substrat donneur. Pour réduire les risques de casse de la couche transférée, ce document prévoit de coller un substrat formant un raidisseur sur le substrat support ou donneur, le substrat raidisseur ayant un coefficient de dilatation thermique proche de celui du substrat sur lequel il est collé.

Encore une autre solution connue est décrite dans le document US 6 884 697. Celle-ci vise à obtenir une rugosité homogène sur l'ensemble de la surface des couches obtenues. Pour cela, le substrat donneur fragilisé est placé à l'horizontal dans le four permettant le recuit thermique de fracture et des moyens de préhension sont prévus pour la manutention à l'horizontale des couches afin d'éviter tout mouvement d'une couche l'une sur l'autre qui pourrait engendrer la formation de rayures.

Bien que satisfaisantes pour améliorer le transfert de la couche mince par fracture, ces solutions ne permettent toutefois pas de réduire les risques de casse de la couche restante du substrat donneur (le négatif) obtenue lors de la fracture.

### Objet et résumé de l'invention

La présente invention vise à remédier aux inconvénients précités en proposant un procédé permettant de limiter considérablement le nombre de casses des négatifs lors de la fracture.

Ce but est atteint grâce à un procédé de fracture d'une structure composite selon un plan de fragilisation défini entre deux couches, le procédé comprenant la réalisation d'une fracture de la structure le long du plan de fragilisation, caractérisé en ce que lors de la fracture la structure est maintenue contre des raidisseurs disposés de part et d'autre de la structure et espacés de celle-ci.

La présence de raidisseurs de part et d'autre de la structure permet d'assurer le maintien des différents matériaux de la structure dans un contact dit « maintenu » au moment de la libération d'énergie lors de la fracture (par opposition à un contact dit « relâché »). Lors de la fracture, l'énergie libérée est amortie par les raidisseurs en contact maintenu avec la structure si bien que l'onde de choc est absorbée, ce qui permet de limiter considérablement les risques de casse du négatif.

Selon une disposition avantageuse, on place la structure composite entre deux raidisseurs, l'espacement cumulé entre chaque raidisseur et la structure étant maintenu non nul et inférieur à 500 micromètres lors de la fracture.

Selon une autre disposition avantageuse, les raidisseurs ont un diamètre qui est au minimum inférieur de 50% au diamètre de la structure composite.

Lors de la fracture, la structure composite peut être disposée sensiblement verticalement ou sensiblement horizontalement.

Le plan de fragilisation de la structure composite peut être formé par implantation ionique et la fracture réalisée par un recuit thermique de la plaque. Dans ce cas, la présence de raidisseurs de part et d'autre de la structure selon l'invention conduit à réduire davantage les risques de casse du négatif.

En effet, il est connu que l'implantation d'espèces ioniques dans la structure composite créée des microcavités dans le matériau qui forment une zone fragilisée. Ces microcavités se développent lors de l'application du budget thermique de recuit jusqu'à conduire à la fracture du matériau le long du plan de fragilisation. Or, lorsque la structure fragilisée comporte des matériaux ayant des coefficients de dilatation thermique différents, tels le germanium sur silicium, le silicium sur le quartz, GaAs ou InP sur silicium, ces matériaux se dilatent de manière différente lors de l'application du budget thermique et la structure forme une flèche si ses surfaces ne sont pas maintenues. L'énergie libérée au moment de la fracture, qui peut être localement très forte, peut alors provoquer la casse du négatif. En revanche, en présence de raidisseurs, cette énergie est contenue ou redistribuée si bien que l'onde de choc résultante est absorbée, ce qui évite la casse du négatif.

De plus, le maintien de la structure en contact maintenu permet d'induire le développement des microcavités dans la direction du plan de fragilisation et de minimiser leur développement dans la direction de l'épaisseur de la structure. La pression résultante est ainsi diminuée dans le sens de l'épaisseur de la structure et la contrainte est uniforme sur l'ensemble de la zone fragilisée diminuant ainsi les points de compression locaux.

La structure composite peut être constituée de deux substrats ayant des coefficients de dilatation thermique différents et peut être réalisée par un assemblage l'un contre l'autre de deux substrats, l'un des deux substrats comportant un plan de fragilisation.

L'invention a également pour objet un logement pour nacelle d'installation de recuit thermique d'une structure composite à fracturer, le logement étant apte à recevoir une structure composite à fracturer selon un plan de fragilisation défini entre deux couches, caractérisé en ce qu'il comporte en outre deux éléments raidisseurs espacés l'un de l'autre et alignés parallèlement l'un à l'autre, l'espacement cumulé entre chaque élément raidisseur et la structure composite étant non nul et inférieur à 500 micromètres.

L'invention a encore pour objet une installation de recuit thermique d'une structure composite à fracturer selon un plan de fragilisation défini entre deux couches, l'installation comportant un four et une nacelle apte à recevoir une pluralité de structures composites, chaque structure composite étant placée dans un logement tel que défini précédemment.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- les figures 1A à 1C sont des vues schématiques en coupe montrant une technique connue de couche sur un substrat, par procédé de fracture de substrat ;
- la figure 2 montre une installation pour la mise en oeuvre d'un procédé selon l'invention ; et
- la figure 3 est une loupe de la figure 2.

### Description détaillée de modes de réalisation

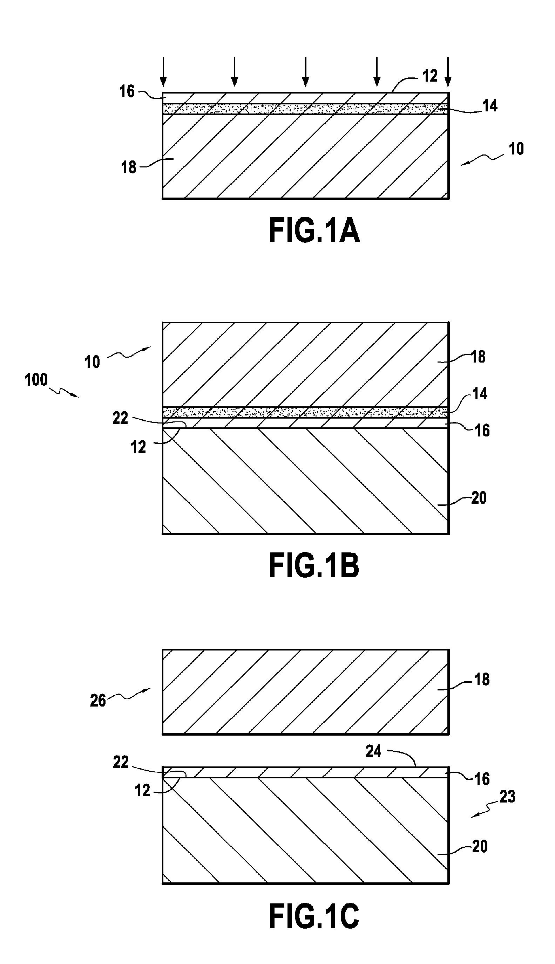

Les figures 1A à 1C représentent un exemple de fabrication d'une couche sur un substrat selon la technologie connue Smart Cut^{®}.

Sur la figure 1A, la référence 10 désigne un substrat donneur (ou source) d'une structure composite. Le substrat donneur peut par exemple être une plaque de GaN.

Selon une première étape, une implantation ionique est réalisée dans le substrat donneur 10. L'implantation correspond à un bombardement ionique de la face plane 12 du substrat donneur par des espèces ioniques telles que des ions d'hydrogène et/ou d'hélium par exemple (le bombardement est représenté par des flèches sur la figure 1A).

La nature des espèces implantées, les doses et énergies d'implantation sont choisies en fonction de l'épaisseur de la couche que l'on souhaite transférer et des propriétés physico-chimiques du substrat implanté.

Les ions implantés ont pour but de former un plan de fragilisation 14 délimitant une couche mince 16 à transférer qui est située du côté de la face plane 12 qui a subi une implantation et une autre couche 18 formant le reste du substrat et appelée le négatif.

De façon optionnelle, l'implantation ionique peut être réalisée au travers d'une couche additionnelle formée sur la face plane 12 du substrat donneur (par exemple SiO₂) de façon à éviter les contaminations de surface.

L'étape suivante consiste à coller la face plane 12 de la couche mince 16 à transférer avec une face 22 d'un substrat support (ou récepteur) 20. Dans le cas d'un substrat donneur en GaN, le substrat support peut par exemple être une plaque de saphir.

Le substrat donneur 10 et le substrat support 20 peuvent présenter des coefficients de dilatation thermique différents.

De façon connue en soi, l'étape de collage correspond à la mise en contact intime du substrat donneur 10 avec le substrat support 20 par adhésion moléculaire et/ou collage électrostatique, cette étape de collage étant suivie d'un traitement thermique de stabilisation du collage.

La figure 1B représente les deux substrats associés, la face plane 22 du substrat support 20 adhérant à la face plane 12 du substrat donneur 10.

Par ailleurs, il est parfois nécessaire de déposer une couche de collage et/ou une couche d'accrochage (par exemple en SiO₂ et/ou Si₃N₄) sur au moins un des deux substrats avant leur mise en contact pour améliorer le collage et le maintien sur la structure composite.

Dans une dernière étape dite de fracture, un budget thermique est appliqué à la structure ainsi obtenue pour détacher la couche mince 16 par fracture au niveau du plan de fragilisation 14 formé dans le substrat donneur 10 et obtenir le transfert de cette couche mince 16 sur le substrat support 20.

Cette étape de fracture consiste par exemple à appliquer à l'ensemble un recuit thermique dans une gamme de température de l'ordre de 80°C à 500°C pour permettre le transfert de la couche mince 16 sur le substrat support.

Suite à cette étape de détachement, on obtient la structure 23 qui est représentée à la figure 1C.

La rugosité de la face externe 24 de cette structure 23 peut éventuellement être réduite par polissage et la surface préparée pour une utilisation ultérieure telle que pour l'épitaxie.

La couche restante 26 du substrat donneur, dénommée négatif, est recyclée après polissage et nettoyage de sa surface pour être utilisée à nouveau comme substrat donneur dans un nouveau transfert de couche mince.

Afin de limiter les risques de casse du négatif lors de l'étape de fracture de la structure obtenue par collage du substrat donneur 10 sur le substrat support 20, il est prévu, selon l'invention, de maintenir lors de cette étape la structure en contact contre des raidisseurs disposés de part et d'autre de la structure.

Par contact maintenu lors de la fracture, on entend un maintien de la structure dans un espacement très limité pendant cette étape. Il est à noter que ce contact maintenu ne consiste ni à coller ni à fixer sur quelle que forme que ce soit les raidisseurs sur la structure.

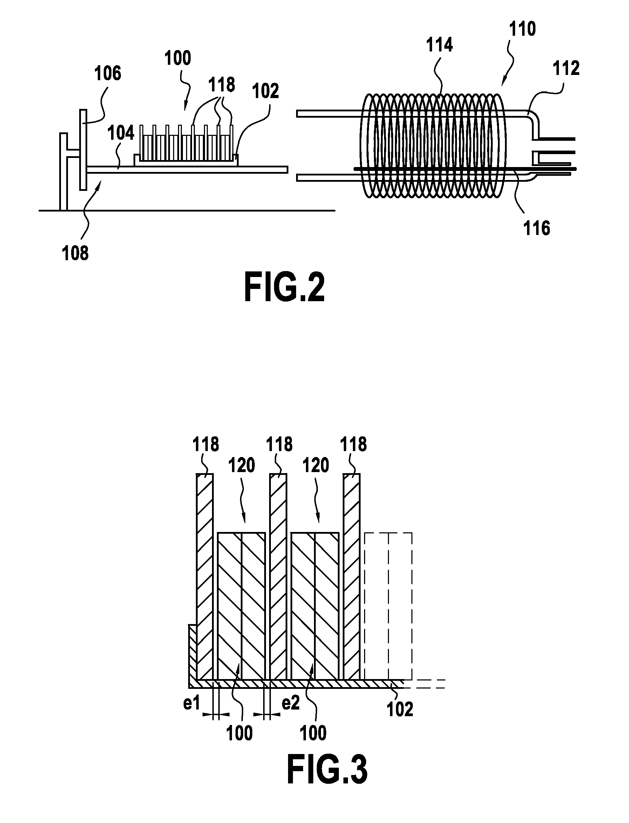

La figure 2 représente un exemple d'installation de mise en oeuvre d'un tel procédé de fracture appliqué à un recuit thermique de fracture pour des structures disposées à la verticale.

Les recuits thermiques de fracture sont classiquement mis en oeuvre dans des fours de recuits pouvant traiter simultanément plusieurs structures composites.

La figure 2 montre ainsi une pluralité de structures composites 100 à fracturer disposées dans un réceptacle 102 tel qu'une nacelle en saphir ou quartz par exemple, les structures composites étant alignées parallèlement les unes aux autres.

La nacelle 102 est elle-même placée sur une pelle 104 fixée à une porte 106 d'obturation de la gueule du four.

L'ensemble 108 formé par la nacelle 102, la pelle 104 et la porte 106 est mobile par rapport à une structure de four 110 qui comprend une tube de process en quartz 112 autour duquel est enroulé un élément chauffant 114. Une canne pyrométrique 116 équipée de thermocouples est également prévue.

Le four de la figure 2 est représenté en position ouverte. En position fermée, l'ensemble 108 est engagé dans la structure de four 110, la porte 106 obstruant la gueule du four.

La figure 3 représente plus en détails une partie de la nacelle 102 dans laquelle sont disposées les structures composites 100.

La nacelle comporte une pluralité d'éléments raidisseurs 118 disposés à la verticale et alignés parallèlement les uns aux autres, l'espacement entre deux éléments raidisseurs adjacents formant un logement 120 dans lequel est disposé une structure composite 100 à fracturer.

L'espacement défini entre les différents éléments raidisseurs 118 de la nacelle est réglable de sorte que l'on peut choisir l'épaisseur de chacun des logements 120.

Les éléments raidisseurs 118 qui viennent en appui contre les faces de la structure composite à fracturer sont des parois en saphir, quartz ou tout autre matériau constitutif de la nacelle.

Comme le coefficient de dilatation thermique des éléments raidisseurs n'est pas prépondérant dans le mécanisme d'absorption de l'énergie libérée au moment de la fracture, les matériaux de ces éléments ne sont choisis que pour être suffisamment résistants mécaniquement face à l'énergie libérée lors du recuit thermique.

Le diamètre de ces raidisseurs peut être supérieur à celui de la structure composite à fracturer et il est au minimum inférieur de 50% - et de préférence au minimum inférieur de 5% - au diamètre de la structure composite.

L'espacement entre les raidisseurs est calculé en fonction de l'épaisseur de la structure à fracturer 100 de sorte que l'espacement cumulé entre chaque raidisseur et la structure est maintenu inférieur à 500 micromètres lors du recuit de fracture (sur la figure 3, l'espacement cumulé est représenté par l'addition des espacements e1 et e2).

De manière générale, l'espacement cumulé entre les raidisseurs et la structure composite à fracturer est régulé en fonction du diamètre de la structure et de la différence de coefficient de dilatation thermique entre les substrats constituants la structure (ces paramètres influencent en effet la formation et l'intensité de la flèche dans la structure lors de l'application du budget thermique).

Selon un exemple, une structure composite à fracturer d'un diamètre de deux pouces (soit 5,08 cm) constituée d'une plaque de GaN fragilisée et collée sur une plaque de saphir est insérée dans un logement 120 dont les éléments raidisseurs 118 sont espacés de façon à laisser un espacement cumulé de 320 micromètres lors du recuit de fracture.

Des essais réalisés avec une telle configuration ont permis de montrer que le nombre de casses des négatifs lors de la fracture peut être réduit de 80% à 10%. Des résultats similaires ont été obtenus avec une configuration semblable dans laquelle l'espacement cumulé était de 330 micromètres.

Par ailleurs, la casse de négatifs est réduite avec des structures composites disposées aussi bien verticalement (figure 3) que horizontalement (non représenté sur les figures).

En outre, avec une telle nacelle 102, les éléments raidisseurs 118 et les structures composites 100 sont maintenus grâce à des barreaux de maintien (non représentés sur les figures). Dans une variante de réalisation, les barreaux de la nacelle pourraient comporter des encoches de maintien des éléments raidisseurs et des structures composites.

On décrira maintenant un exemple de réalisation du procédé selon l'invention.

Le substrat donneur est une plaque de GaN ayant un plan de fragilisation formé par implantation d'ions H⁺ avec une énergie de 30 à 250 keV et une dose de l'ordre de 10¹⁷ at/cm².

Le substrat support est une plaque en saphir.

Une couche de collage telle que du SiO₂ est déposée et préparée sur la face du substrat donneur et/ou du substrat support pour le collage des substrats. Le collage est activé par plasma et les deux substrats mis en contact intime par collage hydrophile.

La structure d'un diamètre de deux pouces (soit 5,08 cm) ainsi obtenue est placée dans un logement de la nacelle d'un four de recuit thermique tel que décrit précédemment entre deux raidisseurs formés dans du quartz (ou tout autre matériau équivalent qui est suffisamment résistant mécaniquement). L'espacement cumulé entre chaque raidisseur et la structure est de 320 micromètres.

La structure ainsi positionnée dans le four est soumise à une rampe de température jusqu'à 500°C environ pour renforcer le collage des substrats et réaliser le recuit de fracture.

Après retour à une température ambiante, le négatif et le substrat constitué d'une couche mince de GaN sur un support en saphir sont récupérés intacts par des moyens de préhension adaptés. En particulier, le négatif est parfaitement intact et peut être réutilisé après recyclage.

## Revendications

1. Procédé de fracture d'une structure composite (100) selon un plan de fragilisation défini entre deux couches, le procédé comprenant la réalisation d'une fracture de la structure le long du plan de fragilisation, **caractérisé en ce que** lors de la fracture la structure est maintenue contre des raidisseurs (118) disposés de part et d'autre de la structure et espacés de celle-ci.

2. Procédé selon la revendication 1, dans lequel on place la structure composite (100) entre deux raidisseurs (118), l'espacement cumulé entre chaque raidisseur et la structure étant maintenu non nul et inférieur à 500 micromètres lors de la fracture.

3. Procédé selon la revendication 2, dans lequel les raidisseurs (118) ont un diamètre qui est au minimum inférieur de 50% au diamètre de la structure composite.

4. Procédé selon l'une quelconque des revendications 1 à 3, dans lequel lors de la fracture la structure composite (100) est disposée sensiblement verticalement.

5. Procédé selon l'une quelconque des revendications 1 à 3, dans lequel lors de la fracture la structure composite (100) est disposée sensiblement horizontalement.

6. Procédé selon l'une quelconque des revendications 1 à 5, dans lequel le plan de fragilisation de la structure composite (100) est formé par implantation ionique.

7. Procédé selon l'une quelconque des revendications 1 à 6, dans lequel la fracture est réalisée par un recuit thermique de la structure composite.

8. Procédé selon l'une quelconque des revendications 1 à 7, dans lequel la structure composite est constituée de deux substrats ayant des coefficients de dilatation thermique différents.

9. Procédé selon l'une quelconque des revendications 1 à 8, dans lequel la structure composite est réalisée par un assemblage l'un contre l'autre de deux substrats (10, 20), l'un des deux substrats comportant un plan de fragilisation.

10. Logement (120) pour nacelle (102) d'installation de recuit thermique d'une structure composite à fracturer, le logement étant apte à recevoir une structure composite (100) à fracturer selon un plan de fragilisation défini entre deux couches, **caractérisé en ce qu'**il comporte en outre deux éléments raidisseurs (118) espacés l'un de l'autre et alignés parallèlement l'un à l'autre, l'espacement cumulé entre chaque élément raidisseur et la structure composite étant non nul et inférieur à 500 micromètres.

11. Logement selon la revendication 10, dans lequel les raidisseurs (118) ont un diamètre qui est au minimum inférieur de 50% au diamètre de la structure composite à fracturer.

12. Installation de recuit thermique d'une structure composite à fracturer selon un plan de fragilisation défini entre deux couches, l'installation comportant un four (110) et une nacelle (102) apte à recevoir une pluralité de structures composites (100), **caractérisée en ce que** chaque structure composite est placée dans un logement (120) selon l'une des revendications 10 et 11.
